(19) **Europäisches Patentamt European Patent Office Office européen des brevets**

(11) **EP 4 239 232 B1**

(12) **EUROPEAN PATENT SPECIFICATION**

(45) Date of publication and mention of the grant of the patent:
**30.04.2025 Bulletin 2025/18**

(21) Application number: **21890977.8**

(22) Date of filing: **28.10.2021**

(51) International Patent Classification (IPC):
**F16K 31/04** *(2006.01)*    **F16K 37/00** *(2006.01)*
**G01R 33/00** *(2006.01)*

(52) Cooperative Patent Classification (CPC):
**F16K 31/04; F16K 37/0033; F16K 37/0041; F25B 41/35; G01R 33/072;** Y02B 30/70

(86) International application number:
**PCT/CN2021/127139**

(87) International publication number:
**WO 2022/100450 (19.05.2022 Gazette 2022/20)**

(54) **ELECTRONIC EXPANSION VALVE AND MONITORING METHOD FOR ELECTRONIC EXPANSION VALVE**

ELEKTRONISCHES EXPANSIONSVENTIL UND ÜBERWACHUNGSVERFAHREN FÜR EIN ELEKTRONISCHES EXPANSIONSVENTIL

DÉTENDEUR ÉLECTRONIQUE ET PROCÉDÉ DE SURVEILLANCE D'UN DÉTENDEUR ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.11.2020 CN 202011248724**

(43) Date of publication of application:
**06.09.2023 Bulletin 2023/36**

(73) Proprietor: **Zhejiang Dunan Artificial Environment Co., Ltd.**
**Shaoxing, Zhejiang 311835 (CN)**

(72) Inventors:
• **SONG, Zhiguo**
**Shaoxing, Zhejiang 311835 (CN)**
• **WANG, Fugang**
**Shaoxing, Zhejiang 311835 (CN)**
• **DENG, Yuezhong**
**Shaoxing, Zhejiang 311835 (CN)**
• **DONG, Shenghai**
**Shaoxing, Zhejiang 311835 (CN)**

(74) Representative: **Penza, Giancarlo**
**Bugnion S.p.A.**
**Viale Lancetti, 17**
**20158 Milano (IT)**

(56) References cited:
EP-A1- 3 690 294     CN-A- 111 365 511
CN-U- 210 240 731     CN-U- 210 240 731
CN-U- 213 809 121     CN-U- 213 809 122
DE-A1- 102019 206 197     JP-A- 2003 042 325
JP-A- 2003 042 325

## Description

### Technical Field

The present invention relates to the technical field of flow control apparatuses, and in particular to an electronic expansion valve and a monitoring method for an electronic expansion valve.

### Background

Presently, an electronic expansion valve includes an electric motor. The electric motor is controlled by a controller to rotate, and drives a rotor to rotate, and rotation of the electric motor is blocked when the electric motor encounters an obstacle during rotation. When rotation of the electronic expansion valve is blocked, the electronic expansion valve will abnormally work if the controller cannot accurately detect rotation blocking and take corresponding measures; or the electronic expansion valve will also abnormally work if the controller wrongly reports rotation blocking information of the electric motor. The rotor of the electronic expansion valve has two rotation directions, is in a rising phase when rotating towards a first direction, and is in a falling phase when rotating towards a second direction. A rotation condition of the rotor cannot be determined by the controller. EP 3 690 294 A1 provides a configuration of an electronic expansion valve in which the Hall sensor is arranged at the periphery close to the rotor. When the rotor rotates, the N poles and S poles of the rotor alternately pass by the Hall sensor which generates a periodic feedback signal from which the controller assesses the operating state of the electronic expansion valve including normal operation and rotor blocking.

That is, the rotation condition of the rotor cannot be determined in the electronic expansion valve in the related art.

### Summary

The main objective of the present invention is to provide an electronic expansion valve which is defined in claim 1 and a monitoring method for an electronic expansion valve which is defined in claim 10, so as to solve the problem that a rotation condition of a rotor is able to not be determined in an electronic expansion valve in the related art.

In order to achieve the above objective, according to one embodiment of the present invention, an electronic expansion valve is provided. The electronic expansion valve includes: a frame body, the frame body being provided with an accommodating cavity and a mounting cavity; an induction magnetic ring, the induction magnetic ring being movably arranged in the accommodating cavity in a height direction of the accommodating cavity, and the mounting cavity being at least located on a circumferential outer side of an active area of the accommodating cavity in which the induction magnetic ring is located; and a Hall sensor, there are multiple Hall sensors, at least two Hall sensors of the multiple Hall sensors being located in the mounting cavity and being arranged around a circumferential side of the accommodating cavity, the at least two Hall sensors of the multiple Hall sensors being located at the same height, and the induction magnetic ring being always in a detection range of the multiple Hall sensors.

In an embodiment of the present invention, an included angle X between projections of centers of induction portions of two adjacent Hall sensors of the multiple Hall sensors and a center of the induction magnetic ring in a height direction of the accommodating cavity and a number n of magnetic poles of the induction magnetic ring satisfy:

$$X=N*(360/n)+(360/2/n) \qquad \text{Equation (1)}$$

a unit of the included angle X being a degree; and N being an integer.

In an embodiment of the present invention, distances between the at least two Hall sensors of the multiple Hall sensors and the induction magnetic ring are the same.

In an embodiment of the present invention, a distance L between centers of induction portions of two adjacent Hall sensors of the multiple Hall sensors, a number n of magnetic poles of the induction magnetic ring and a projection distance r from the centers of the multiple Hall sensors to a center of the induction magnetic ring in a height direction of the accommodating cavity satisfy:

$$L=2*r*\sin[(2*N+1)*\pi/(2*n)] \qquad \text{Equation (2).}$$

In an embodiment of the present invention, the induction magnetic ring has a rising position and a falling position, and a circumferential side wall of the induction magnetic ring includes an induction surface section, a distance between the induction surface section and an inner side wall of the accommodating cavity being unchanged in an height direction of the accommodating cavity, a projection of a top side of the induction surface section to the multiple Hall sensors being located in the induction portions of the multiple Hall sensors when the induction magnetic ring is located in the falling position, and a projection of a bottom side of the induction surface section to the multiple Hall sensors being located in the induction portions of the multiple Hall sensors when the induction magnetic ring is located in the rising position.

In an embodiment of the present invention, the circumferential side wall of the induction magnetic ring further includes an upper protective surface section located above the induction surface section and a lower protective surface section located below the induction surface section, the upper protective surface section being in arc transition with a top surface of the induction magnetic ring, and the lower protective surface section being in arc transition with a bottom surface of the induction magnetic ring.

In an embodiment of the present invention, a height of the induction surface section is greater than a motion stroke of the induction magnetic ring in the height direction of the accommodating cavity.

In an embodiment of the present invention, the electronic expansion valve further includes drive rotors, where the drive rotors are arranged in the accommodating cavity, the induction magnetic ring is arranged on one side of the drive rotors close to the mounting cavity, the drive rotors drive the induction magnetic ring to rotate, and the drive rotors have a number the same as that of the magnetic poles of the induction magnetic ring.

In an embodiment of the present invention, the multiple Hall sensors are attached to an outer side wall of the accommodating cavity.

In an embodiment of the present invention, the electronic expansion valve further includes multiple fixing frames, where the multiple Hall sensors are attached to the outer side wall of the accommodating cavity by means of the multiple fixing frames, and at least two fixing frames of the multiple fixing frames are attached to the at least two Hall sensors of the multiple Hall sensors in a one-to-one corresponding manner, so as to limit the multiple Hall sensors between the outer side wall of the accommodating cavity and the multiple fixing frames.

According to another aspect of the present invention, a monitoring method for an electronic expansion valve is provided. The electronic expansion valve has drive rotors driving an induction magnetic ring of the electronic expansion valve to rotate and multiple Hall sensors for monitoring the induction magnetic ring, and at least two Hall sensors of the multiple Hall sensors are spaced around a circumferential side of the induction magnetic ring; and the monitoring method for an electronic expansion valve includes: simultaneously collecting, by the multiple Hall sensors, a motion condition of the induction magnetic ring respectively, so as to form moving magnetic field curves; comparing the moving magnetic field curves collected by different Hall sensors of the multiple Hall sensors; and determining motion conditions of the drive rotors according to phase differences and/or periods of the different moving magnetic field curves.

In an embodiment of the present invention, when the motion conditions of the drive rotors are determined according to the phase differences and/pr periods of the different moving magnetic field curves, the motion conditions of the drive rotors at least include whether the drive rotors rotate, the drive rotors being in a rising phase and the drive rotors being in a falling phase.

In an embodiment of the present invention, when the motion conditions of the drive rotors are determined according to the phase differences and the periods of the different moving magnetic field curves, the drive rotors being in the rising phase or the falling phase is determined according to the phase differences of the different moving magnetic field curves; and whether the drive rotors rotate is determined according to the periods of the different moving magnetic field curves.

In an embodiment of the present invention, the electronic expansion valve is provided with an accommodating cavity and a mounting cavity, the induction magnetic ring is movably arranged in the accommodating cavity in a height direction of the accommodating cavity, and the mounting cavity is at least located on a circumferential outer side of an active area of the accommodating cavity in which the induction magnetic ring is located; and the at least two Hall sensors are located in the mounting cavity and being arranged around a circumferential side of the accommodating cavity, and an included angle X between projections of centers of induction portions of two adjacent Hall sensors of the multiple Hall sensors and a center of the induction magnetic ring in the height direction of the accommodating cavity and a number n of magnetic poles of the induction magnetic ring satisfy:

$$X=N*(360/n)+(360/2/n) \qquad \text{Equation (1)}$$

a unit of the included angle X being a degree; and N being an integer.

In an embodiment of the present invention, distances between the at least two Hall sensors of the multiple Hall sensors and the induction magnetic ring are the same.

In an embodiment of the present invention, a distance L between centers of induction portions of two adjacent Hall sensors of the multiple Hall sensors, a number n of the magnetic poles of the induction magnetic ring and a projection distance r from the centers of the multiple Hall sensors to the center of the induction magnetic ring in the height direction of the accommodating cavity satisfy:

$$L=2*r*sin[(2*N+1)*\pi/(2*n)] \qquad \text{Equation (2).}$$

The technical solution of the present invention is applied, and the electronic expansion valve includes the frame body, the induction magnetic ring and the multiple Hall sensors, where the frame body is provided with the accommodating cavity and the mounting cavity; the induction magnetic ring is movably arranged in the accommodating cavity in the height direction of the accommodating cavity, and the mounting cavity is at least located in the circumferential outer side of the active area of the accommodating cavity in which the induction magnetic ring is located; and the at least two Hall sensors are arranged, are located in the mounting cavity, are arranged around the circumferential side of the accommodating cavity, and are located at the same height, and the induction magnetic ring is always located in the detection range of the multiple Hall sensors.

The accommodating cavity is provided, such that the induction magnetic ring is able to move in the height direction of the accommodating cavity, and moreover, the induction magnetic ring is able to further rotate in the accommodating cavity, and arrangement of the accommodating cavity is able to reduce interference of other structural members on motion of the induction magnetic ring, such that the induction magnetic ring is able to work stably. By arranging the at least two Hall sensors, each Hall sensor is able to collect a magnetic field of the induction magnetic ring during motion and form the moving magnetic field curve. By analyzing a relation between the at least two moving magnetic field curves to determine the motion conditions of the drive rotors, whether the drive rotors are in the rising phase or the falling phase is further determined, and whether the drive rotors rotate is able to be further determined. The problem that a rotation condition of a rotor is able to not be determined in an electronic expansion valve in the related art is solved.

## Brief Description of the Drawings

The accompanying drawings of the description forming a part of the present invention serve to provide a further understanding of the present invention, and illustrative examples of the present invention and the description of the illustrative examples serve to explain the present invention and are not to be construed as unduly limiting the present invention. In the accompanying drawings:

Fig. 1 shows a schematic structural diagram of an electronic expansion valve according to an optional embodiment of the present invention;

Fig. 2 shows an enlarged view of a portion P in Fig. 1;

Fig. 3 shows a view of the electronic expansion valve of Fig. 1 from an angle;

Fig. 4 shows a schematic diagram of an angle relation between an induction magnetic ring and a Hall sensor in Fig. 3;

Fig. 5 shows a sine wave signal generated when the induction magnetic ring rotates in a forward direction in Fig. 1;

Fig. 6 shows a sine wave signal generated when the induction magnetic ring rotates in a reverse direction in Fig. 1;

Fig. 7 shows a square wave signal generated when the induction magnetic ring rotates in the forward direction in Fig. 1; and

Fig. 8 shows a square wave signal generated when the induction magnetic ring rotates in the reverse direction in Fig. 1.

The above-mentioned figures include the following reference numerals:
10, frame body; 20, accommodating cavity; 30, mounting cavity; 40, induction magnetic ring; 41, induction surface section; 42, upper protective surface section; 43, lower protective surface section; 50, Hall sensor; and 60, drive rotor.

## Detailed Description of the Embodiments

It should be noted that examples in the present invention and features in the examples is able to be combined with each other without conflict. The present invention will be described in detail below with reference to the accompanying drawings in conjunction with the examples.

It should be pointed out that all technical and scientific terms used in the present invention have the same meanings as commonly understood by those of ordinary skill in the art to which the present invention belongs unless otherwise indicated.

In the present invention, in the absence of any description to the contrary, orientation words, such as "upper, lower, top and bottom", used are usually used for directions shown in the figures, or used for an upright, vertical or gravity direction of a component itself; and similarly, for the convenience of understanding and description, "inside and outside" refers to the inside and outside relative to contours of the components themselves, but the above orientation words are not used to limit the present invention.

In order to solve the problem that a rotation condition of a rotor is able to not be determined in an electronic expansion valve in the related art, the present invention provides an electronic expansion valve and a monitoring method for an electronic expansion valve.

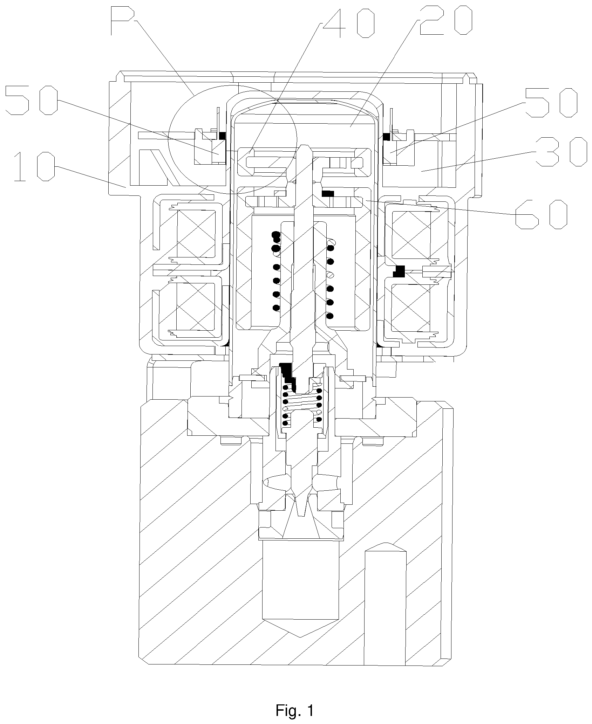

As shown in Figs. 1-8, an electronic expansion valve includes a frame body 10, an induction magnetic ring 40 and a Hall sensor 50, where the frame body 10 is provided with an accommodating cavity 20 and a mounting cavity 30; the induction magnetic ring 40 is movably arranged in the accommodating cavity 20 in a height direction of the accommodating cavity 20, and the mounting cavity 30 is at least located on a circumferential outer side of an active area of the accommodating cavity 20 in which the induction magnetic ring 40 is located; and there are multiple t Hall sensors 50, the at least two Hall sensors 50 of the multiple Hall sensors 50 are located in the mounting cavity 30 and are arranged around a circumferential side of the accommodating cavity 20, the at least two Hall sensors 50 are located at the same height, and the induction magnetic ring 40 is always in a detection range of the multiple Hall sensors 50.

The accommodating cavity 20 is provided, such that the induction magnetic ring 40 is able to move in the height direction of the accommodating cavity 20, and moreover, the induction magnetic ring 40 is able to further rotate in the accommodating cavity 20, and arrangement of the accommodating cavity 20 is able to reduce interference of other structural members on motion of the induction magnetic ring 40, such that the induction magnetic ring 40 is able to work stably. By arranging the at least two Hall sensors 50, each Hall sensor 50 is able to collect a magnetic field of the induction magnetic ring 40 during motion and form a moving magnetic field curve. By analyzing a relation between the at least two moving magnetic field curves to determine motion conditions of the drive rotors 60, whether the drive rotors 60 are in a rising phase or a falling phase is further determined, and whether the drive rotors 60 rotate may be further determined. The problem that a rotation condition of a rotor may not be determined in an electronic expansion valve in the related art is solved.

As shown in Fig. 1, the electronic expansion valve further includes drive rotors 60, where the drive rotors 60 are arranged in the accommodating cavity 20, the induction magnetic ring 40 is arranged on one side of the drive rotors 60 close to the mounting cavity 30, the drive rotors 60 drive the induction magnetic ring 40 to rotate, and the drive rotors 60 have a number the same as that of the magnetic poles of the induction magnetic ring 40. The drive rotors 60 drive the induction magnetic ring 40 to rotate, and the number of magnetic poles of the drive rotors 60 is the same as that of the magnetic poles of the induction magnetic ring 40, such that the influence of the magnetic poles of the drive rotors 60 on the magnetic field generated by the induction magnetic ring 40 may be avoided, so as to ensure that the multiple Hall sensors 50 may stably work.

Of course, the induction magnetic ring 40 and the drive rotors 60 are able to be integrated, such that synchronous rotation of the drive rotors 60 and the induction magnetic ring 40 is facilitated.

It should be noted that the drive rotors 60 drive the induction magnetic ring 40 to rotate, the drive rotors 60 are connected to the induction magnetic ring 40 together, and the induction magnetic ring 40 is able to be synchronously driven to move when the drive rotors 60 rotate. Or, the drive rotors 60 rotate, such that the induction magnetic ring 40 rotates; the drive rotors 60 are in a rising phase, such that the induction magnet ring 40 is in a rising phase; and the drive rotors 60 are in a falling phase, such that the induction magnetic ring 40 is in a falling phase. That is, motion of the induction magnetic ring 40 is able to indicate motion of the drive rotors 60. By analyzing a relation between the multiple moving magnetic field curves, the motion conditions of the drive rotors 60 also are determined, whether the drive rotors 60 are in the rising phase or the falling phase is further determined, and whether the drive rotors 60 rotate is further determined. It should be noted that since rotation directions of the drive rotors are different when the drive rotors 60 are in the rising phase and in the falling phase, a phase difference of the two moving magnetic field curves is opposite. When the electronic expansion valve is designed, it is necessary to give whether the drive rotors are the rising phase or the falling phase when which curve precedes. Or, it is necessary to give that the positive or negative phase difference of the two moving magnetic field curves corresponds to the rising phase or the falling phase, so as to determine whether the drive rotors 60 are in the rising phase or the falling phase.

With the two Hall sensors 50 as an example, one Hall sensor 50 is marked as a first Hall sensor, the other Hall sensor 50 is marked as a second Hall sensor, and a phase difference is the moving magnetic field curve of the first Hall sensor minus the moving magnetic field curve of the second Hall sensor. The drive rotors 60 being in the rising phase is determined when the phase difference of the two moving magnetic field profiles is positive, and the drive rotors 60 being in the falling phase is determined when the phase difference of the two moving magnetic field curves is negative. Thus, whether the drive rotors 60 are in the rising phase or the falling phase may be determined according to the positive or negative phase difference of the two moving magnetic field curves.

Since the drive rotors 60 rotate uniformly, the moving magnetic field curve of the induction magnetic ring 40 collected by the multiple Hall sensors 50 is regular, a period of the moving magnetic field curve of the induction magnetic ring 40 is changed when the drive rotors 60 no longer rotate or no longer rotate uniformly, and whether rotation of the electronic expansion valve is blocked is determined by observing the period of the moving magnetic field curve. When the electronic expansion valve is designed, the period of the moving magnetic field curve of the induction magnetic ring 40 during normal motion is collected in advance. During working of the electronic expansion valve, if the period of the moving magnetic field curve is less than a period of the moving magnetic field curve of the induction magnetic ring 40 during normal motion, rotation of the electronic expansion valve is blocked.

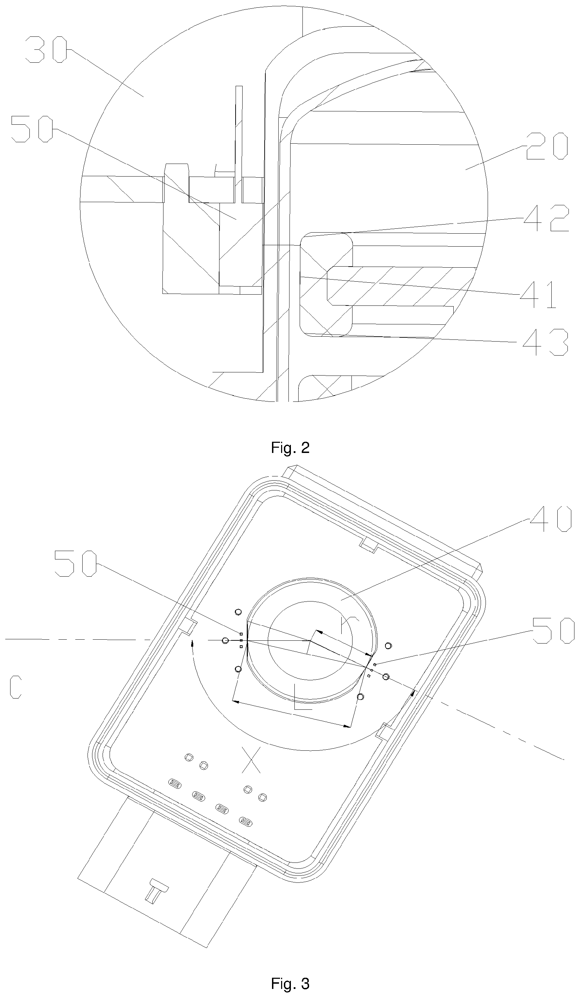

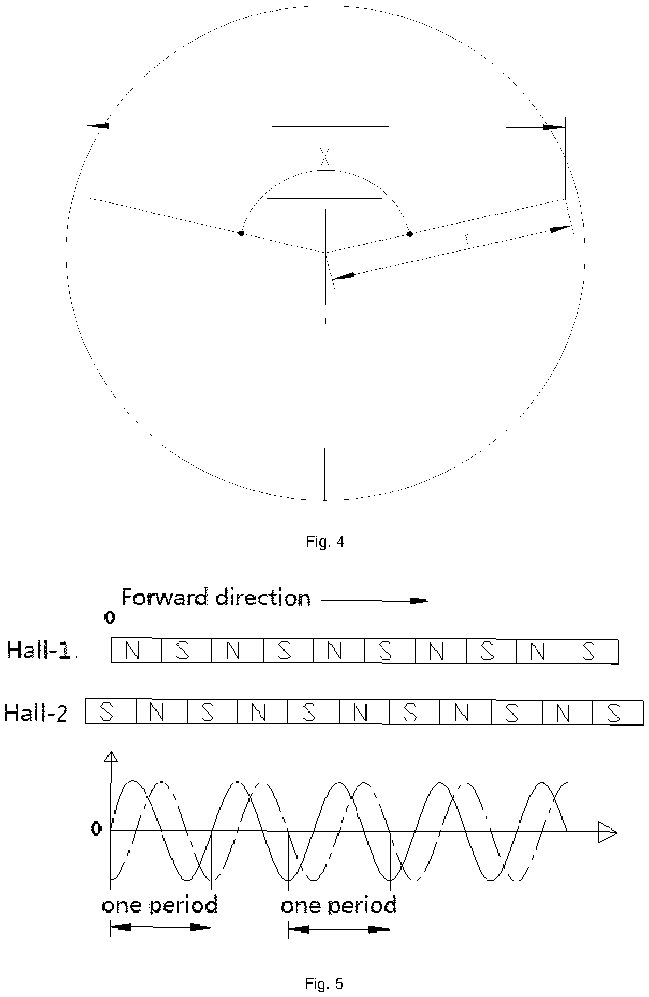

As shown in Figs. 3 and 4, an included angle X between projections of centers of induction portions of the two adjacent Hall sensors (50) and a center of the induction magnetic ring (40) in a height direction of the accommodating cavity (20) and a number n of magnetic poles of the induction magnetic ring (40) satisfy:

$$X=N*(360/n)+(360/2/n) \qquad \text{Equation (1)}$$

a unit of the included angle X being a degree; and N being an integer.

The included angle between the two adjacent Hall sensors 50 is determined according to the number n of magnetic poles of the induction magnetic ring, and moreover, how many Hall sensors 50 are placed may be also computed. Such an arrangement is able to accurately determine the motion condition of the induction magnetic ring by means of the moving magnetic field curve.

It should be noted that an angle is generally an acute, and therefore a degree of the included angle X is greater than 0 degree and less than or equal to 180 degrees. Thus, computation of how many Hall sensors 50 are placed is facilitated.

A relation between the included angle X and the number n of the magnetic poles is a check function.

Specifically, distances between the at least two Hall sensors 50 and the induction magnetic ring 40 are the same. Such an arrangement enables the strength of a magnetic field of the induction magnetic ring 40 collected by each Hall sensor 50 to be the same, and peaks and periods of the at least two moving magnetic field curves are the same, such that determination of the motion conditions of the drive rotors 60 is facilitated by means of the at least two moving magnetic field curves.

As shown in Figs. 3 and 4, a distance L between centers of induction portions of the two adjacent Hall sensors 50, the number n of magnetic poles of the induction magnetic ring 40 and a projection distance r from the centers of the multiple Hall sensors 50 to a center of the induction magnetic ring 40 in a height direction of the accommodating cavity 20 satisfy:

$$L=2*r*sin[(2*N+1)*\pi/(2*n)] \qquad \text{Equation (2).}$$

A unit of the distance L is a centimeter, and a unit of the projection distance r is a centimeter.

Of course, the distance L and the projection distance r are length units. The units of the distance L and the projection distance r also are length units of millimeters, meters, etc.

Under the condition that the number n of the magnetic poles of the induction magnetic ring 40 is determined, there is a linear function between the distance L and the projection distance r. The distance L between the centers of the induction portions of the two adjacent Hall sensors 50 is related to the number n of the magnetic poles of the induction magnetic ring 40 and the projection distance r from the centers of the multiple Hall sensors 50 to the center of the induction magnetic ring 40 in the height direction of the accommodating cavity 20, and the distance L between the centers of the induction portions of the designed two adjacent Hall sensors 50 is different in the different number n of the magnetic poles of the induction magnetic ring 40.

In an embodiment, the induction magnetic ring 40 has a rising position and a falling position, and a circumferential side wall of the induction magnetic ring 40 includes an induction surface section 41, a distance between the induction surface section 41 and an inner side wall of the accommodating cavity 20 being unchanged in the height direction of the accommodating cavity 20, a projection of a top side of the induction surface section 41 to the multiple Hall sensors 50 being located in the induction portions of the multiple Hall sensors 50 when the induction magnetic ring 40 is located in the falling position, and a projection of a bottom side of the induction surface section 41 to the multiple Hall sensors 50 being located in the induction portions of the multiple Hall sensors 50 when the induction magnetic ring 40 is located in the rising position. The magnetic poles of the induction magnetic ring 40 are arranged on the induction surface section 41, and the distance between the induction surface section 41 and an inner side wall of the accommodating cavity 20 is unchanged in the height direction of the accommodating cavity 20, such that the multiple Hall sensors 50 collect the periodically stable magnetic field for determining the motion conditions of the drive rotors 60 by means of the moving magnetic field curves. Such an arrangement enables the multiple Hall sensors 50 to always detect the induction surface section 41, so as to ensure that the multiple Hall sensors 50 is able to monitor the motion condition of the induction magnetic ring 40 in real time.

As shown in Fig. 2, the circumferential side wall of the induction magnetic ring 40 further includes an upper protective surface section 42 located above the induction surface section 41 and a lower protective surface section 43 located below the induction surface section 41, the upper protective surface section 42 being in arc transition with a top surface of the induction magnetic ring 40, and the lower protective surface section 43 being in arc transition with a bottom surface of the induction magnetic ring 40. Arrangement of the upper protective surface section 42 and the lower protective surface section 43 is able to protect the induction surface section 41, so as to avoid collision of the induction surface section 41 by other structures, thereby ensuring working stability of the induction surface section 41, so as to produce a stable magnetic field. The upper protective surface section 42 is in arc transition with the top surface of the induction magnetic ring 40, and the lower protective surface section 43 is in arc transition with the bottom surface of the induction magnetic ring 40, and such an arrangement facilitates motion of the induction magnetic ring 40 in the accommodating cavity 20, such that scratching of the induction magnetic ring 40 against the inner side wall of the accommodating cavity 20 is avoided, and working stability of the induction magnetic ring 40 is ensured.

Specifically, a height of the induction surface section 41 is greater than a motion stroke of the induction magnetic ring 40 in the height direction of the accommodating cavity 20. Such an arrangement enables the induction surface section 41 to always be in the detection range of the multiple Hall sensors 50, and ensures that the multiple Hall sensors 50 is able to detect the induction surface section 41 in real time.

As shown in Fig. 1, the multiple Hall sensors 50 are attached to an outer side wall of the accommodating cavity 20. Such as arrangement facilitates mounting of the multiple Hall sensors 50, and facilitates the same distance between the multiple Hall sensors 50 and the induction magnetic ring 40, so as to ensure detection stability of the multiple Hall sensors 50.

It should be noted that the accommodating cavity 20 has a cylindrical shape, and the induction magnetic ring 40 has a circular pie shape.

The electronic expansion valve further includes multiple fixing frames, where the multiple Hall sensors 50 are attached to the outer side wall of the accommodating cavity 20 by means of the multiple fixing frames, and at least two fixing frames of the multiple fixing frames are attached to the at least two Hall sensors 50 in a one-to-one corresponding manner, so as to limit the multiple Hall sensors 50 between the outer side wall of the accommodating cavity 20 and the multiple fixing frames. Arrangement of the multiple fixing frames provides mounting positions for the multiple Hall sensors 50, such that the multiple Hall sensors 50 are attached to the outer side wall of the accommodating cavity 20. The multiple fixing frames further protect the multiple Hall sensors 50, so as to avoid collision of other structural members on the multiple Hall sensors 50, thereby ensuring stable work of the multiple Hall sensors 50.

The electronic expansion valve has drive rotors 60 driving an induction magnetic ring 40 of the electronic expansion valve to rotate and multiple Hall sensors 50 for monitoring the induction magnetic ring 40, and the at least two Hall sensors 50 are spaced around a circumferential side of the induction magnetic ring 40; and a monitoring method for an electronic expansion valve includes: simultaneously collect, by the multiple Hall sensors 50, a motion condition of the induction magnetic ring 40 respectively, so as to form moving magnetic field curves; compare the moving magnetic field curves collected by different Hall sensors; and determine motion conditions of the drive rotors 60 according to phase differences and/or periods of the different moving magnetic field curves.

By arranging the at least two Hall sensors 50, each Hall sensor 50 is able to collect the magnetic field of the induction magnetic ring 40 during motion and form a moving magnetic field curve. The motion conditions of the drive rotors 60 are determined by analyzing a relation of the at least two moving magnetic field curves. Specifically, when the motion conditions of the drive rotors 60 are determined according to the phase differences and/or periods of the different moving magnetic field curves, the motion conditions of the drive rotors 60 at least include whether the drive rotors 60 rotate, the drive rotors 60 being in a rising phase and the drive rotors 60 being in a falling phase. Since rotation directions of the drive rotors are different when the drive rotors 60 are in the rising phase and in the falling phase, a phase difference of the two moving magnetic field curves is opposite. Therefore, whether the drive rotors 60 are in the rising phase or the falling phase is able to be determined according to the phase differences. Since the drive rotors 60 rotate uniformly, the moving magnetic field curve of the induction magnetic ring 40 collected by the multiple Hall sensors 50 is regular, a period of the moving magnetic field curve of the induction magnetic ring 40 is changed when the drive rotors 60 no longer rotate or no longer rotate uniformly, and whether rotation of the induction magnetic ring is blocked is determined by observing the period of the moving magnetic field curve.

Specifically, when the motion conditions of the drive rotors 60 are determined according to the phase differences and/or the periods of the different moving magnetic field curves, the drive rotors 60 being in the rising phase or the falling phase is determined according to the phase differences of the different moving magnetic field curves; and whether the drive rotors 60 rotate is determined according to the periods of the different moving magnetic field curves.

It should be noted that since rotation directions of the drive rotors are different when the drive rotors 60 are in the rising phase and in the falling phase, a phase difference of the two moving magnetic field curves is opposite. When the electronic expansion valve is designed, it is necessary to give whether the drive rotors are the rising phase or the falling phase when which curve precedes. Or, it is necessary to give that the positive or negative phase difference of the two moving magnetic field curves corresponds to the rising phase or the falling phase, so as to determine whether the drive rotors 60 are in the rising phase or the falling phase.

Since the drive rotors 60 rotate uniformly, the moving magnetic field curve of the induction magnetic ring 40 collected by the multiple Hall sensors 50 is regular, periods of the moving magnetic field curves of the drive rotors 60 are changed when the drive rotors 60 no longer rotate or no longer rotate uniformly, and whether rotation of the induction magnetic ring is blocked is determined by observing the period of the moving magnetic field curve. When the electronic expansion valve is designed, the period of the moving magnetic field curve of the induction magnetic ring 40 during normal motion is collected in advance. During working of the electronic expansion valve, if the period of the moving magnetic field curve is less than a period of the moving magnetic field curve of the induction magnetic ring 40 during normal motion, rotation of the electronic expansion valve is blocked.

With the two Hall sensors 50 as an example, the two Hall sensors 50 are arranged, when the motion conditions of the drive rotors 60 are determined according to the phase differences and/or the periods of the different moving magnetic field curves, if the phase difference of the two moving magnetic field curves is positive, the drive rotors 60 being in the rising phase is determined; and if the phase difference of the two moving magnetic field curves is negative, the drive rotors 60 being in the falling phase is determined. One Hall sensor 50 is marked as a first Hall sensor, the other Hall sensor 50 is marked as a second Hall sensor, and the phase difference is the moving magnetic field curve of the first Hall sensor minus the moving magnetic field curve of the second Hall sensor. The drive rotors 60 being in the rising phase is determined when the phase difference of the two moving magnetic field curves is positive, and the drive rotors 60 being in the falling phase is determined when the phase difference of the two moving magnetic field curves is negative. Therefore, whether the drive rotors 60 are in the rising phase or the falling phase may be determined according to the positive or negative phase difference of the two moving magnetic field curves.

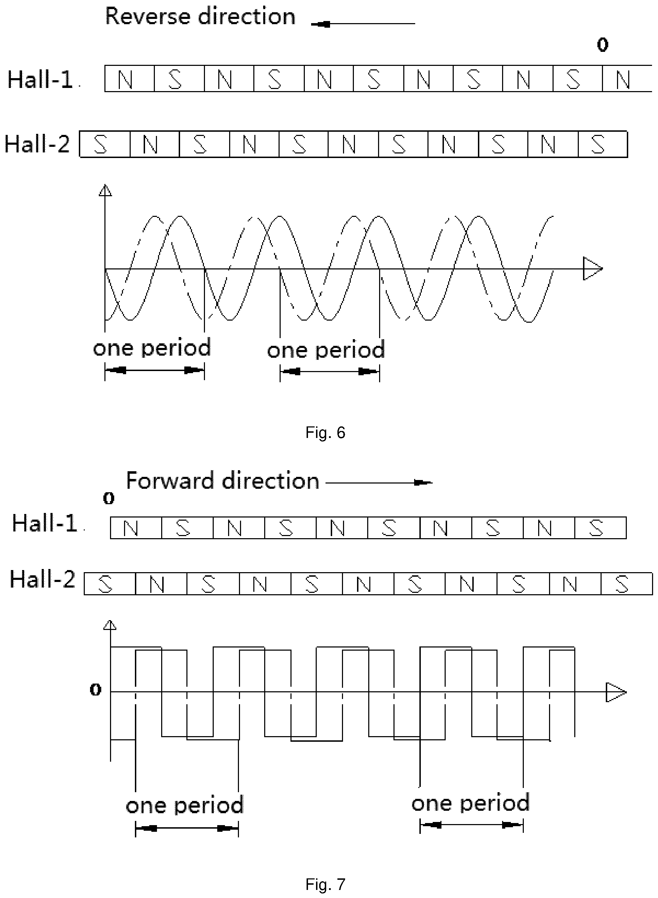

In particular examples shown in Figs. 5 and 6, a solid line is a moving magnetic field curve of a first Hall sensor 50, and a dashed line is a moving magnetic field curve of a second Hall sensor 50. As shown in Fig. 5, when drive rotors 60 rotate in a forward direction, the solid line is ahead of the dashed line, and a phase difference is positive. As shown in Fig. 6, when drive rotors 60 rotate in a reverse direction, the dashed line is ahead of the solid line, and a phase difference is negative.

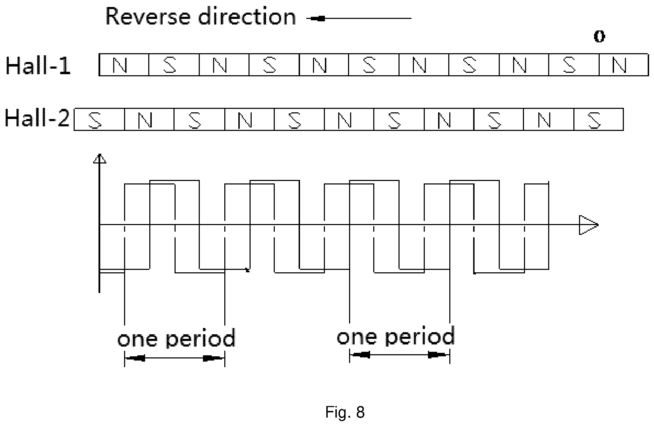

In particular examples shown in Figs. 7 and 8, moving magnetic field curves of Hall sensors 50 are square waves, a solid line is the moving magnetic field curve of a first Hall sensor 50, and a dashed line is a moving magnetic field curve of a second Hall sensor 50. As shown in Fig. 7, when drive rotors 60 rotate in a forward direction, the solid line is ahead of the dashed line, and a phase difference is positive. As shown in Fig. 8, when drive rotors 60 rotate in a reverse direction, the dashed line is ahead of the solid line, and a phase difference is negative.

Of course, the at least two Hall sensors 50 are arranged, the phase difference of the moving magnetic field curves of the two Hall sensors 50 are only referred, and the phase difference of the moving magnetic field curves of the at least two Hall sensors 50 are also referred.

As shown in Figs. 3 and 4, an included angle X between projections of centers of induction portions of the two adjacent Hall sensors 50 and a center of the induction magnetic ring 40 in the height direction of the accommodating cavity 20 and the number n of magnetic poles of the induction magnetic ring 40 satisfy:

$$X=N*(360/n)+(360/2/n) \qquad \text{Equation (1)}$$

a unit of the included angle X being a degree; and N being an integer.

The included angle between the two adjacent Hall sensors 50 is determined according to the number n of magnetic poles of the induction magnetic ring, and moreover, how many Hall sensors 50 are placed may be also computed. Such an arrangement is accurately determine the motion condition of the induction magnetic ring by means of the moving magnetic field curve.

Specifically, distances between the at least two Hall sensors 50 and the induction magnetic ring 40 are the same. Such an arrangement enables the strength of a magnetic field of the induction magnetic ring 40 collected by each Hall sensor 50 to be the same, and peaks and periods of the at least two moving magnetic field curves are the same, such that determination of the motion conditions of the drive rotors 60 is facilitated by means of the at least two moving magnetic field curves.

As shown in Figs. 3 and 4, a distance L between the centers of the induction portions of the two adjacent Hall sensors 50, the number n of the magnetic poles of the induction magnetic ring 40 and a projection distance r from the centers of the multiple Hall sensors 50 to the center of the induction magnetic ring 40 in the height direction of the accommodating cavity 20 satisfy:

$$L=2*r*sin[(2*N+1)*\pi/(2*n)] \qquad \text{Equation (2).}$$

A unit of the distance L is a centimeter, and a unit of the projection distance r is a centimeter.

Of course, the distance L and the projection distance r are length units. The units of the distance L and the projection distance r also are length units of millimeters, meters, etc.

Under the condition that the number n of the magnetic poles of the induction magnetic ring 40 is determined, there is a linear function between the distance L and the projection distance r.

The distance L between the centers of the induction portions of the two adjacent Hall sensors 50 is related to the number n of the magnetic poles of the induction magnetic ring 40 and the projection distance r from the centers of the multiple Hall sensors 50 to the center of the induction magnetic ring 40 in the height direction of the accommodating cavity 20, and the distance L between the centers of the induction portions of the designed two adjacent Hall sensors 50 is different in the different number n of the magnetic poles of the induction magnetic ring 40.

The electronic expansion valve further includes a coil assembly, a valve body assembly and a sleeve, where the coil assembly is arranged in the frame body 10 and located on an outer side of the drive rotors 60, the valve body assembly includes a valve seat and a valve needle, the valve needle moving along with the drive rotors 60 to open and close a valve port on the valve seat, the sleeve is arranged in the accommodating cavity 20, is fixedly connected to the valve body assembly, and is provided with a cavity, and the drive rotors 60 move in the sleeve.

What are described above are merely the preferred examples of the present invention and are not used for limiting the present invention, the scope of protection of the present invention is defined by the appended claims.

**Claims**

1. An electronic expansion valve, comprising:

   a frame body (10), the frame body (10) being provided with an accommodating cavity (20) and a mounting cavity (30);
   an induction magnetic ring (40), the induction magnetic ring (40) being movably arranged in the accommodating cavity (20) in a height direction of the accommodating cavity (20), and the mounting cavity (30) being at least located on a circumferential outer side of an active area of the accommodating cavity (20) in which the induction magnetic ring (40) is located; and
   a Hall sensor (50), there are multiple Hall sensors (50), at least two Hall sensors (50) of the multiple Hall sensors (50) being located in the mounting cavity (30) and being arranged around a circumferential side of the accommodating cavity (20), the at least two Hall sensors (50) of the multiple Hall sensors (50) being located at the same height, and the induction magnetic ring (40) being always in a detection range of the multiple Hall sensors (50).

2. The electronic expansion valve as claimed in claim 1, wherein an included angle X between projections of centers of induction portions of two adjacent Hall sensors (50) of the multiple Hall sensors (50) and a center of the induction magnetic ring (40) in a height direction of the accommodating cavity (20) and a number n of magnetic poles of the induction magnetic ring (40) satisfy:

$$X=N*(360/n)+(360/2/n) \qquad \text{Equation (1)}$$

   a unit of the included angle X being a degree; and N being an integer.

3. The electronic expansion valve as claimed in claim 1, wherein distances between the at least two Hall sensors (50) of the multiple Hall sensors (50) and the induction magnetic ring (40) are the same.

4. The electronic expansion valve as claimed in claim 3, wherein a distance L between centers of induction portions of two adjacent Hall sensors (50) of the multiple Hall sensors (50), a number n of magnetic poles of the induction magnetic ring (40) and a projection distance r from the centers of the multiple Hall sensors (50) to a center of the induction magnetic ring (40) in a height direction of the accommodating cavity (20) satisfy:

$$L=2*r*sin[(2*N+1)*\pi /(2*n)] \qquad \text{Equation (2)}.$$

5. The electronic expansion valve as claimed in any one of claims 1-4, wherein the induction magnetic ring (40) has a rising position and a falling position, and a circumferential side wall of the induction magnetic ring (40) comprises an induction surface section (41), a distance between the induction surface section (41) and an inner side wall of the accommodating cavity (20) being unchanged in an height direction of the accommodating cavity (20),

   a projection of a top side of the induction surface section (41) to the multiple Hall sensors (50) being located in the induction portions of the multiple Hall sensors (50) when the induction magnetic ring (40) is located in the falling position, and

a projection of a bottom side of the induction surface section (41) to the multiple Hall sensors (50) being located in the induction portions of the multiple Hall sensors (50) when the induction magnetic ring (40) is located in the rising position.

6. The electronic expansion valve as claimed in claim 5, wherein the circumferential side wall of the induction magnetic ring (40) further comprises an upper protective surface section (42) located above the induction surface section (41) and a lower protective surface section (43) located below the induction surface section (41), the upper protective surface section (42) being in arc transition with a top surface of the induction magnetic ring (40), and the lower protective surface section (43) being in arc transition with a bottom surface of the induction magnetic ring (40).

7. The electronic expansion valve as claimed in claim 5, wherein a height of the induction surface section (41) is greater than a motion stroke of the induction magnetic ring (40) in the height direction of the accommodating cavity (20).

8. The electronic expansion valve as claimed in any one of claims 1-4, further comprising drive rotors (60), wherein the drive rotors (60) are arranged in the accommodating cavity (20), the induction magnetic ring (40) is arranged on one side of the drive rotors (60) close to the mounting cavity (30), the drive rotors (60) drive the induction magnetic ring (40) to rotate, and the drive rotors (60) have a number the same as that of the magnetic poles of the induction magnetic ring (40).

9. The electronic expansion valve as claimed in any one of claims 1-4, wherein the multiple Hall sensors (50) are attached to an outer side wall of the accommodating cavity (20), the electronic expansion valve further comprising multiple fixing frames, wherein the multiple Hall sensors (50) are attached to the outer side wall of the accommodating cavity (20) by means of the multiple fixing frames, and at least two fixing frames of the multiple fixing frames are attached to the at least two Hall sensors (50) of the multiple Hall sensors (50) in a one-to-one corresponding manner, so as to limit the multiple Hall sensors (50) between the outer side wall of the accommodating cavity (20) and the multiple fixing frames.

10. A monitoring method for an electronic expansion valve, wherein the electronic expansion valve has drive rotors (60) driving an induction magnetic ring (40) of the electronic expansion valve to rotate and multiple Hall sensors (50) for monitoring the induction magnetic ring (40), and at least two Hall sensors (50) of the multiple Hall sensors (50) are spaced around a circumferential side of the induction magnetic ring (40); and the monitoring method for an electronic expansion valve comprises:

simultaneously collecting, by the multiple Hall sensors (50), a motion condition of the induction magnetic ring (40) respectively, so as to form moving magnetic field curves;

comparing the moving magnetic field curves collected by different Hall sensors (50) of the multiple Hall sensors (50); and

determining motion conditions of the drive rotors (60) according to phase differences of the different moving magnetic field curves; or determining motion conditions of the drive rotors (60) according to periods of phase differences of the different moving magnetic field curves; or determining motion conditions of the drive rotors (60) according to phase differences and periods of the different moving magnetic field curves.

11. The monitoring method for an electronic expansion valve as claimed in claim 10, wherein

when the motion conditions of the drive rotors (60) are determined according to the phase differences of the different moving magnetic field curves, the motion conditions of the drive rotors (60) at least comprise whether the drive rotors (60) rotate, the drive rotors (60) being in a rising phase and the drive rotors (60) being in a falling phase; or

when the motion conditions of the drive rotors (60) are determined according to the periods of the phase differences of the different moving magnetic field curves, the motion conditions of the drive rotors (60) at least comprise whether the drive rotors (60) rotate, the drive rotors (60) being in a rising phase and the drive rotors (60) being in a falling phase; or

when the motion conditions of the drive rotors (60) are determined according to the phase differences and the periods of the different moving magnetic field curves, the motion conditions of the drive rotors (60) at least comprise whether the drive rotors (60) rotate, the drive rotors (60) being in a rising phase and the drive rotors (60) being in a falling phase.

12. The monitoring method for an electronic expansion valve as claimed in claim 11, wherein when the motion conditions of the drive rotors (60) are determined according to the phase differences and the periods of the different moving magnetic field curves,

    the drive rotors (60) being in the rising phase or the falling phase is determined according to the phase differences of the different moving magnetic field curves; and whether the drive rotors (60) rotate is determined according to the periods of the different moving magnetic field curves.

13. The monitoring method for an electronic expansion valve as claimed in claim 12, wherein the electronic expansion valve is provided with an accommodating cavity (20) and a mounting cavity (30), the induction magnetic ring (40) is movably arranged in the accommodating cavity (20) in a height direction of the accommodating cavity (20), and the mounting cavity (30) is at least located on a circumferential outer side of an active area of the accommodating cavity (20) in which the induction magnetic ring (40) is located; and the at least two Hall sensors (50) of the multiple Hall sensors (50) are located in the mounting cavity (30) and being arranged around a circumferential side of the accommodating cavity (20), and an included angle X between projections of centers of induction portions of two adjacent Hall sensors (50) of the multiple Hall sensors (50) and a center of the induction magnetic ring (40) in the height direction of the accommodating cavity (20) and a number n of magnetic poles of the induction magnetic ring (40) satisfy:

$$X=N*(360/n)+(360/2/n) \qquad \text{Equation (1)}$$

    a unit of the included angle X being a degree; and N being an integer.

14. The monitoring method for an electronic expansion valve as claimed in claim 13, wherein distances between the at least two Hall sensors (50) of the multiple Hall sensors (50) and the induction magnetic ring (40) are the same.

15. The monitoring method for an electronic expansion valve as claimed in claim 14, wherein a distance L between the centers of the induction portions of the two adjacent Hall sensors (50) of the multiple Hall sensors (50), a number n of the magnetic poles of the induction magnetic ring (40) and a projection distance r from the centers of the multiple Hall sensors (50) to the center of the induction magnetic ring (40) in the height direction of the accommodating cavity (20) satisfy:

$$L=2*r*\sin[(2*N+1)*\pi/(2*n)] \qquad \text{Equation (2).}$$

**Patentansprüche**

1. Elektronisches Expansionsventil, umfassend:

    einen Rahmenkörper (10), wobei der Rahmenkörper (10) mit einem Aufnahmehohlraum (20) und einem Montagehohlraum (30) versehen ist;
    einen Induktionsmagnetring (40), wobei der Induktionsmagnetring (40) in dem Aufnahmehohlraum (20) in einer Höhenrichtung des Aufnahmehohlraums (20) beweglich angeordnet ist und sich der Montagehohlraum (30) zumindest auf einer Umfangsaußenseite eines aktiven Bereichs des Aufnahmehohlraums (20) befindet, in dem sich der Induktionsmagnetring (40) befindet; und
    einen Hallsensor (50), mehrere Hallsensoren (50) vorhanden sind, wobei sich mindestens zwei Hallsensoren (50) der mehreren Hallsensoren (50) in dem Montagehohlraum (30) befinden und um eine Umfangsseite des Aufnahmehohlraums (20) herum angeordnet sind, wobei sich die mindestens zwei Hallsensoren (50) der mehreren Hallsensoren (50) auf gleicher Höhe befinden und sich der Induktionsmagnetring (40) stets in einem Erfassungsbereich der mehreren Hallsensoren (50) befindet.

2. Elektronisches Expansionsventil nach Anspruch 1, wobei ein eingeschlossener Winkel X zwischen Projektionen von Mittelpunkten von Induktionsabschnitten von zwei benachbarten Hallsensoren (50) der mehreren Hallsensoren (50) und einem Mittelpunkt des Induktionsmagnetrings (40) in einer Höhenrichtung des Aufnahmehohlraums (20) und einer Anzahl n von Magnetpolen des Induktionsmagnetrings (40) erfüllt:

```
X=N*(360/n)+(360/2/n) Gleichung (1)
```

wobei eine Einheit des eingeschlossenen Winkels X ein Grad ist; und N eine ganze Zahl ist.

3. Elektronisches Expansionsventil nach Anspruch 1, wobei Abstände zwischen den zumindest zwei Hallsensoren (50) der mehreren Hallsensoren (50) und dem Induktionsmagnetring (40) gleich sind.

4. Elektronisches Expansionsventil nach Anspruch 3, wobei ein Abstand L zwischen Mittelpunkten von Induktionsabschnitten von zwei benachbarten Hallsensoren (50) der mehreren Hallsensoren (50), eine Anzahl n von Magnetpolen des Induktionsmagnetrings (40) und ein Projektionsabstand r von den Mittelpunkten der mehreren Hallsensoren (50) zu einem Mittelpunkt des Induktionsmagnetrings (40) in einer Höhenrichtung des Aufnahmehohlraums (20) erfüllen:

$$L=2*r*sin[(2*N+1)*\pi/(2*n)] \quad \text{Gleichung (2)}.$$

5. Elektronisches Expansionsventil nach einem der Ansprüche 1-4, wobei der Induktionsmagnetring (40) eine ansteigende Position und eine abfallende Position aufweist und eine Umfangsseitenwand des Induktionsmagnetrings (40) eine Induktionsflächensektion (41) umfasst, wobei ein Abstand zwischen der Induktionsflächensektion (41) und einer inneren Seitenwand des Aufnahmehohlraums (20) in einer Höhenrichtung des Aufnahmehohlraums (20) unverändert ist,

wobei sich eine Projektion einer Oberseite der Induktionsflächensektion (41) auf die mehreren Hallsensoren (50) in den Induktionsabschnitten der mehreren Hallsensoren (50) befindet, wenn sich der Induktionsmagnetring (40) in der abfallenden Position befindet, und
wobei sich eine Projektion einer Unterseite der Induktionsflächensektion (41) auf die mehreren Hallsensoren (50) in den Induktionsabschnitten der mehreren Hallsensoren (50) befindet, wenn sich der Induktionsmagnetring (40) in der ansteigenden Position befindet.

6. Elektronisches Expansionsventil nach Anspruch 5, wobei die Umfangsseitenwand des Induktionsmagnetrings (40) ferner eine oberen Schutzflächensektion (42), die sich über der Induktionsflächensektion (41) befindet, und eine untere Schutzflächensektion (43), die sich unter der Induktionsflächensektion (41) befindet, umfasst, wobei die obere Schutzflächensektion (42) in einem Bogenübergang mit einer oberseitigen Fläche des Induktionsmagnetrings (40) ist und die untere Schutzflächensektion (43) in einem Bogenübergang mit einer unterseitigen Fläche des Induktionsmagnetrings (40) ist.

7. Elektronisches Expansionsventil nach Anspruch 5, wobei eine Höhe der Induktionsflächensektion (41) größer ist als ein Bewegungshub des Induktionsmagnetrings (40) in der Höhenrichtung des Aufnahmehohlraums (20).

8. Elektronisches Expansionsventil nach einem der Ansprüche 1-4, ferner umfassend Antriebsrotoren (60), wobei die Antriebsrotoren (60) in dem Aufnahmehohlraum (20) angeordnet sind, der Induktionsmagnetring (40) auf einer Seite der Antriebsrotoren (60) in der Nähe des Montagehohlraums (30) angeordnet ist, die Antriebsrotoren (60) den Induktionsmagnetring (40) zur Drehung antreiben und die Antriebsrotoren (60) eine Anzahl aufweisen, die der Anzahl der Magnetpole des Induktionsmagnetrings (40) gleich ist.

9. Elektronisches Expansionsventil nach einem der Ansprüche 1-4, wobei die mehreren Hallsensoren (50) an einer äußeren Seitenwand des Aufnahmehohlraums (20) angebracht sind, wobei das elektronische Expansionsventil ferner mehrere Befestigungsrahmen umfasst, wobei die mehreren Hallsensoren (50) mittels der mehreren Befestigungsrahmen an der Außenseitenwand des Aufnahmehohlraums (20) angebracht sind und mindestens zwei Befestigungsrahmen der mehreren Befestigungsrahmen an den mindestens zwei Hallsensoren (50) der mehreren Hallsensoren (50) in einer eins-zueins entsprechenden Weise angebracht sind, um die mehreren Hallsensoren (50) zwischen der Außenseitenwand des Aufnahmehohlraums (20) und den mehreren Befestigungsrahmen zu begrenzen.

10. Überwachungsverfahren für ein elektronisches Expansionsventil, wobei das elektronische Expansionsventil Antriebsrotoren (60), die einen Induktionsmagnetring (40) des elektronischen Expansionsventils zum Drehen antreiben, und mehrere Hallsensoren (50) zum Überwachen des Induktionsmagnetrings (40) aufweist und mindestens zwei Hallsensoren (50) der mehreren Hallsensoren (50) um eine Umfangsseite des Induktionsmagnetrings (40) beabstandet sind; und das Überwachungsverfahren für ein elektronisches Expansionsventil umfasst:

gleichzeitiges Erheben jeweils einer Bewegungsbedingung des Induktionsmagnetrings (40) durch die mehreren Hallsensoren (50), um Kurven eines sich bewegenden Magnetfeldes;

Vergleichen der Kurven des sich bewegenden Magnetfeldes, die von verschiedenen Hallsensoren (50) der mehreren Hallsensoren (50) erhoben werden; und

Bestimmen von Bewegungsbedingungen der Antriebsrotoren (60) gemäß Phasendifferenzen der verschiedenen Kurven des sich bewegenden Magnetfeldes; oder Bestimmen von Bewegungsbedingungen der Antriebsrotoren (60) gemäß Perioden von Phasendifferenzen der verschiedenen Kurven des sich bewegenden Magnetfeldes; oder Bestimmen von Bewegungsbedingungen der Antriebsrotoren (60) gemäß Phasendifferenzen und Perioden der verschiedenen Kurven des sich bewegenden Magnetfeldes.

**11.** Überwachungsverfahren für ein elektronisches Expansionsventil nach Anspruch 10, wobei

wenn die Bewegungsbedingungen der Antriebsrotoren (60) gemäß den Phasendifferenzen der verschiedenen Kurven des sich bewegenden Magnetfeldes bestimmt werden, die Bewegungsbedingungen der Antriebsrotoren (60) zumindest umfassen, ob sich die Antriebsrotoren (60) drehen, wobei die Antriebsrotoren (60) in einer ansteigenden Phase sind und die Antriebsrotoren (60) in einer abfallenden Phase sind; oder

wenn die Bewegungsbedingungen der Antriebsrotoren (60) gemäß den Perioden der Phasendifferenzen der verschiedenen Kurven des sich bewegenden Magnetfeldes bestimmt werden, die Bewegungsbedingungen der Antriebsrotoren (60) zumindest umfassen, ob sich die Antriebsrotoren (60) drehen, wobei die Antriebsrotoren (60) in einer ansteigenden Phase sind und die Antriebsrotoren (60) in einer abfallenden Phase sind; oder

wenn die Bewegungsbedingungen der Antriebsrotoren (60) gemäß den Phasendifferenzen und den Perioden der verschiedenen Kurven des sich bewegenden Magnetfeldes bestimmt werden, umfassen die Bewegungsbedingungen der Antriebsrotoren (60) zumindest, ob sich die Antriebsrotoren (60) drehen, wobei die Antriebsrotoren (60) in einer ansteigenden Phase sind und die Antriebsrotoren (60) in einer abfallenden Phase sind.

**12.** Überwachungsverfahren für ein elektronisches Expansionsventil nach Anspruch 11, wobei, wenn die Bewegungsbedingungen der Antriebsrotoren (60) gemäß den Phasendifferenzen und den Perioden der verschiedenen Kurven des sich bewegenden Magnetfeldes bestimmt werden, die Antriebsrotoren (60) in der ansteigenden Phase sind oder in der abfallenden Phase sind, gemäß den Phasendifferenzen der verschiedenen Kurven des sich bewegenden Magnetfeldes bestimmt werden; und ob sich die Antriebsrotoren (60) drehen, gemäß den Perioden der verschiedenen Kurven des sich bewegenden Magnetfeldes bestimmt wird.

**13.** Überwachungsverfahren für ein elektronisches Expansionsventil nach Anspruch 12, wobei das elektronische Expansionsventil mit einem Aufnahmehohlraum (20) und einem Montagehohlraum (30) versehen ist, der Induktionsmagnetring (40) in dem Aufnahmehohlraum (20) in einer Höhenrichtung des Aufnahmehohlraums (20) beweglich angeordnet ist und sich der Montagehohlraum (30) zumindest auf einer Umfangsaußenseite eines aktiven Bereichs des Aufnahmehohlraums (20) befindet, in dem sich der Induktionsmagnetring (40) befindet; und die mindestens zwei Hallsensoren (50) der mehreren Hallsensoren (50) befinden sich im Montagehohlraum (30) und wobei sie um eine Umfangsseite des Aufnahmehohlraums (20) herum angeordnet sind, und ein eingeschlossener Winkel X zwischen Projektionen von Mittelpunkten von Induktionsabschnitten von zwei benachbarten Hallsensoren (50) der mehreren Hallsensoren (50) und einem Mittelpunkt des Induktionsmagnetrings (40) in der Höhenrichtung des Aufnahmehohlraums (20) und einer Anzahl n von Magnetpolen des Induktionsmagnetrings (40) erfüllen:

$$X=N*(360/n)+(360/2/n) \quad \text{Gleichung (1)}$$

wobei eine Einheit des eingeschlossenen Winkels X ein Grad ist; und N eine ganze Zahl ist.

**14.** Überwachungsverfahren für ein elektronisches Expansionsventil nach Anspruch 13, wobei Abstände zwischen den zumindest zwei Hallsensoren (50) der mehreren Hallsensoren (50) und dem Induktionsmagnetring (40) gleich sind.

**15.** Überwachungsverfahren für ein elektronisches Expansionsventil nach Anspruch 14, wobei ein Abstand L zwischen den Mittelpunkten der Induktionsabschnitte der zwei benachbarten Hallsensoren (50) der mehreren Hallsensoren (50), eine Anzahl n der Magnetpole des Induktionsmagnetrings (40) und ein Projektionsabstand r von den Mittelpunkten der mehreren Hallsensoren (50) zum Mittelpunkt des Induktionsmagnetrings (40) in der Höhenrichtung des Aufnahmehohlraums (20) erfüllen:

$$L=2*r*sin[(2*N+1)*\pi/(2*n)] \quad \text{Gleichung (2).}$$

**Revendications**

1. Détendeur électronique, comprenant :

un corps de châssis (10), le corps de châssis (10) étant pourvu d'une cavité de logement (20) et d'une cavité de montage (30) ;
un anneau magnétique à induction (40), l'anneau magnétique à induction (40) étant disposé de manière mobile dans la cavité de logement (20) dans une direction de hauteur de la cavité de logement (20), et la cavité de montage (30) étant au moins située sur un côté extérieur circonférentiel d'une zone active de la cavité de logement (20) dans laquelle l'anneau magnétique à induction (40) est situé ; et
un capteur à effet Hall (50), il y a des capteurs multiples à effet Hall (50), au moins deux capteurs à effet Hall (50) des capteurs multiples à effet Hall (50) étant situés dans la cavité de montage (30) et étant disposés autour d'un côté circonférentiel de la cavité de logement (20), les au moins deux capteurs à effet Hall (50) des capteurs multiples à effet Hall (50) étant situés à la même hauteur, et l'anneau magnétique à induction (40) étant toujours dans une plage de détection des capteurs multiples à effet Hall (50).

2. Détendeur électronique selon la revendication 1, dans lequel un angle inclus X entre les projections des centres des parties à induction de deux capteurs à effet Hall (50) adjacents des capteurs multiples à effet Hall (50) et un centre de l'anneau magnétique à induction (40) dans une direction de hauteur de la cavité de logement (20) et un nombre n de pôles magnétiques de l'anneau magnétique à induction (40) satisfont :

$$X=N*(360/n)+(360/2/n) \text{ Équation (1)}$$

une unité de l'angle inclus X étant un degré ; et N étant un nombre entier.

3. Détendeur électronique selon la revendication 1, dans lequel les distances entre les au moins deux capteurs à effet Hall (50) des capteurs multiples à effet Hall (50) et l'anneau magnétique à induction (40) sont les mêmes.

4. Détendeur électronique selon la revendication 3, dans lequel une distance L entre les centres des parties à induction de deux capteurs à effet Hall (50) adjacents des capteurs multiples à effet Hall (50), un nombre n de pôles magnétiques de l'anneau magnétique à induction (40) et une distance de projection r à partir des centres des capteurs multiples à effet Hall (50) à un centre de l'anneau magnétique à induction (40) dans une direction de hauteur de la cavité de logement (20) satisfont :

$$L=2*r*\sin[(2*N+1)*\pi/(2*n)] \text{ Équation (2).}$$

5. Détendeur électronique selon l'une quelconque des revendications 1-4, dans lequel l'anneau magnétique à induction (40) a une position ascendante et une position descendante, et une paroi latérale circonférentielle de l'anneau magnétique à induction (40) comprend une section de surface à induction (41), une distance entre la section de surface à induction (41) et une paroi latérale intérieure de la cavité de logement (20) étant inchangée dans une direction de hauteur de la cavité de logement (20),

une projection d'un côté supérieur de la section de surface à induction (41) vers les capteurs multiples à effet Hall (50) étant située dans les parties à induction des capteurs multiples à effet Hall (50) lorsque l'anneau magnétique à induction (40) est situé dans la position descendante, et
une projection d'un côté inférieur de la section de surface à induction (41) vers les capteurs multiples à effet Hall (50) étant située dans les parties à induction des capteurs multiples à effet Hall (50) lorsque l'anneau magnétique à induction (40) est situé dans la position ascendante.

6. Détendeur électronique selon la revendication 5, dans lequel la paroi latérale circonférentielle de l'anneau magnétique à induction (40) comprend en outre une section de surface de protection supérieure (42) située au-dessus de la section de surface à induction (41) et une section de surface de protection inférieure (43) située sous la section de surface à induction (41), la section de surface de protection supérieure (42) étant en transition d'arc avec une surface supérieure de l'anneau magnétique à induction (40), et la section de surface de protection inférieure (43) étant en transition d'arc avec une surface inférieure de l'anneau magnétique à induction (40).

7. Détendeur électronique selon la revendication 5, dans lequel une hauteur de la section de surface à induction (41) est supérieure à la course de déplacement de l'anneau magnétique à induction (40) dans la direction de hauteur de la cavité de logement (20).

8. Détendeur électronique selon l'une quelconque des revendications 1-4, comprenant en outre des rotors d'entraînement (60), dans lequel les rotors d'entraînement (60) sont disposés dans la cavité de logement (20), l'anneau magnétique à induction (40) est disposé sur un côté des rotors d'entraînement (60) près de la cavité de montage (30), les rotors d'entraînement (60) entraînent l'anneau magnétique à induction (40) en rotation, et les rotors d'entraînement (60) sont du même nombre que les pôles magnétiques de l'anneau magnétique à induction (40).

9. Détendeur électronique selon l'une quelconque des revendications 1-4, dans lequel les capteurs multiples à effet Hall (50) sont fixés à une paroi latérale extérieure de la cavité de logement (20), le détendeur électronique comprenant en outre des châssis multiples de fixation, dans lequel les capteurs multiples à effet Hall (50) sont fixés à la paroi latérale extérieure de la cavité de logement (20) au moyen des châssis multiples de fixation, et au moins deux châssis de fixation des châssis multiples de fixation sont fixés aux au moins deux capteurs à effet Hall (50) des capteurs multiples à effet Hall (50) de manière correspondante un à un, afin de limiter les capteurs multiples à effet Hall (50) entre la paroi latérale extérieure de la cavité de logement (20) et les châssis multiples de fixation.

10. Procédé de surveillance d'un détendeur électronique, dans lequel le détendeur électronique comporte des rotors d'entraînement (60) entraînant la rotation d'un anneau magnétique à induction (40) du détendeur électronique et des capteurs multiples à effet Hall (50) pour surveiller l'anneau magnétique à induction (40), et au moins deux capteurs à effet Hall (50) des capteurs multiples à effet Hall (50) sont espacés autour d'un côté circonférentiel de l'anneau magnétique à induction (40) ; et le procédé de surveillance d'un détendeur électronique comprend :

recueillir simultanément, par les capteurs multiples à effet Hall (50), une condition de mouvement de l'anneau magnétique à induction (40) respectivement, de manière à former des courbes de champ magnétique mobile ; comparer les courbes de champ magnétique mobile recueillies par différents capteurs à effet Hall (50) des capteurs multiples à effet Hall (50) ; et déterminer les conditions de mouvement des rotors d'entraînement (60) selon des déphasages des différentes courbes de champ magnétique mobile ; ou déterminer les conditions de mouvement des rotors d'entraînement (60) selon des périodes de déphasage des différentes courbes de champ magnétique mobile ; ou déterminer les conditions de mouvement des rotors d'entraînement (60) selon des déphasages et des périodes des différentes courbes de champ magnétique mobile.

11. Procédé de surveillance d'un détendeur électronique selon la revendication 10, dans lequel

lorsque les conditions de mouvement des rotors d'entraînement (60) sont déterminées selon les déphasages des différentes courbes de champ magnétique mobile, les conditions de mouvement des rotors d'entraînement (60) comprennent au moins si les rotors d'entraînement (60) tournent, les rotors d'entraînement (60) étant dans une phase ascendante et les rotors d'entraînement (60) étant dans une phase descendante ; ou lorsque les conditions de mouvement des rotors d'entraînement (60) sont déterminées selon les périodes de déphasages des différentes courbes de champ magnétique mobile, les conditions de mouvement des rotors d'entraînement (60) comprennent au moins si les rotors d'entraînement (60) tournent, les rotors d'entraînement (60) étant dans une phase ascendante et les rotors d'entraînement (60) étant dans une phase descendante ; ou lorsque les conditions de mouvement des rotors d'entraînement (60) sont déterminées selon les déphasages et les périodes des différentes courbes de champ magnétique mobile, les conditions de mouvement des rotors d'entraînement (60) comprennent au moins si les rotors d'entraînement (60) tournent, les rotors d'entraînement (60) étant dans une phase ascendante et les rotors d'entraînement (60) étant dans une phase descendante.

12. Procédé de surveillance d'un détendeur électronique selon la revendication 11, dans lequel, lorsque les conditions de mouvement des rotors d'entraînement (60) sont déterminées selon les déphasages et les périodes des différentes courbes de champ magnétique mobile,

la phase ascendante ou descendante des rotors d'entraînement (60) est déterminée selon les déphasages des différentes courbes de champ magnétique mobile ; et la rotation des rotors d'entraînement (60) est déterminée selon les périodes des différentes courbes de champ magnétique mobile.

**13.** Procédé de surveillance d'un détendeur électronique selon la revendication 12, dans lequel le détendeur électronique est pourvu d'une cavité de logement (20) et d'une cavité de montage (30), l'anneau magnétique à induction (40) est disposé de manière mobile dans la cavité de logement (20) dans une direction de hauteur de la cavité de logement (20), et la cavité de montage (30) est au moins située sur un côté extérieur circonférentiel d'une zone active de la cavité de logement (20) dans laquelle l'anneau magnétique à induction (40) est situé ; et les au moins deux capteurs à effet Hall (50) des capteurs multiples à effet Hall (50) sont situés dans la cavité de montage (30) et étant disposés autour d'un côté circonférentiel de la cavité de logement (20), et un angle inclus X entre les projections des centres des parties à induction de deux capteurs à effet Hall (50) adjacents des capteurs multiples à effet Hall (50) et un centre de l'anneau magnétique à induction (40) dans la direction de hauteur de la cavité de logement (20) et un nombre n de pôles magnétiques de l'anneau magnétique à induction (40) satisfont :

$$X=N*(360/n)+(360/2/n) \quad \text{Équation (1)}$$

une unité de l'angle inclus X étant un degré ; et N étant un nombre entier.

**14.** Procédé de surveillance d'un détendeur électronique selon la revendication 13, dans lequel les distances entre les au moins deux capteurs à effet Hall (50) des capteurs multiples à effet Hall (50) et l'anneau magnétique à induction (40) sont les mêmes.

**15.** Procédé de surveillance d'un détendeur électronique selon la revendication 14, dans lequel une distance L entre les centres des parties à induction des deux capteurs à effet Hall (50) adjacents des capteurs multiples à effet Hall (50), un nombre n de pôles magnétiques de l'anneau magnétique à induction (40) et une distance de projection r à partir des centres des capteurs multiples à effet Hall (50) au centre de l'anneau magnétique à induction (40) dans la direction de hauteur de la cavité de logement (20) satisfont :

$$L=2*r*sin[(2*N+1)*\pi/(2*n)] \quad \text{Équation (2)}.$$

Fig. 1

Fig. 2

Fig. 3

Fig. 4

Fig. 5

Reverse direction

Hall-1

Hall-2

one period    one period

Fig. 6

Forward direction

Hall-1

Hall-2

one period    one period

Fig. 7

Fig. 8

**EP 4 239 232 B1**

**Patent documents cited in the description**

- EP 3690294 A1